# EUROPÄISCHE PATENTSCHRIFT

(11) **EP 1 887 847 B1**
(45) Veröffentlichungstag und Bekanntmachung des Hinweises auf die Patenterteilung: **15.06.2011**
(21) Anmeldenummer: 06464001.4
(22) Anmeldetag: 10.08.2006
(51) Int. Cl.: H05K 7/20

(54) **Elektronikeinheit mit abgedichteter Kühlmittelpassage**
Control unit with sealed canal for cooling fluid
Unité électronique avec des canneaux étanches pour le fluide de refroissement

(43) Veröffentlichungstag der Anmeldung: 13.02.2008
(73) Patentinhaber: Continental Automotive GmbH, 30165 Hannover (DE)
(72) Erfinder: Smit, Arnoud, 93059 Regensburg (DE); Bojan, Radu Vasile, 410196 Oradea (RO); Sovagau, Remus, 300708 Timisoara (RO)

(56) Entgegenhaltungen:
- DE-U1-202004 008 004
- JP-A- 11 163 572
- JP-A- 2004 134 542
- US-A1- 2003 053 294

## Beschreibung

Die vorliegende Erfindung betrifft eine Elektronikeinheit, insbesondere Steuergerät für ein Kraftfahrzeug, mit elektrischen und/oder elektronischen Bauelementen, die an einer Oberseite einer wärmeleitenden Elektronik-Bodenplatte angeordnet und thermisch mit dieser Bodenplatte gekoppelt sind, wobei die Bodenplatte wiederum thermisch mit einer Kühlmittelpassage gekoppelt ist.

Derartige Elektronikeinheiten sind in vielfältigen Ausführungen insbesondere auf dem Gebiet der Leistungselektronik bekannt und besitzen den Vorteil, dass im Betrieb der elektrischen bzw. elektronischen Bauelemente entstehende Wärme (Verlustleistung) an ein die Kühlmittelpassage durchströmendes Kühlmedium (z. B. Kühlflüssigkeit wie Wasser) abgegeben werden kann.

Problematisch ist hierbei jedoch ein mehr oder weniger großes Risiko der Undichtigkeit der Kühlmittelpassage, das mit einer solchen Kühlmethode einhergeht. Je nach Art des verwendeten Kühlmittels sowie der damit gekühlten Schaltungsanordnung kann dieses Problem insbesondere bei einer kompakten Bauform der Elektronikeinheit dann besonders gravierend sein, wenn in Folge einer Undichtigkeit austretendes Kühlmittel die Schaltungsanordnung bzw. deren Bauelemente erreichen kann. Ein Beispiel hierfür ist die Wasserkühlung einer Leistungselektronik, in welcher im Betrieb relativ hohe elektrische Spannungen vorliegen. In diesem Fall könnte das Vordringen von Kühlwasser zur Elektronik bzw. das Eindringen von Kühlwasser in ein Elektronikgehäuse Kurzschlüsse verursachen, Bauelemente zerstören, oder sogar einen Brand verursachen. Eine Undichtigkeit der Kühlmittelpassage ist in der Praxis vor allem dann zu erwarten, wenn die Differenz zwischen Kühlmitteldruck und Umgebungsdruck besonders groß ist. Das Risiko des Vordringens von Kühlmittel zur Elektronik ist vor allem dann groß, wenn sowohl die Kühlmittelpassage als auch der von den elektrischen bzw. elektronischen Bauelementen beanspruchte Raum ("Elektronikraum") innerhalb einer mehr oder weniger geschlossenen Gehäusestruktur untergebracht sind.

Eine bekannte Möglichkeit zur Minimierung der vorstehend erläuterten Gefahren ist die Verwendung eines möglichst zuverlässig dicht geschweißten oder gelöteten Kühlers, auf welchen über eine Wärmeleitpaste oder einen Wärmeleitkleber Elektronikmodule oder unbestückte Flachseiten von Schaltungsträgerplatten angebunden (z. B. aufgeschraubt) werden. Die Verwendung von Lot anstelle von Wärmeleitpaste bzw. Wärmeleitkleber ist zumeist nicht praktikabel, da die Elektronikmodule bzw. Elektronikschaltungsträger oftmals demontierbar sein sollen. Außerdem besteht bei Verwendung von Lot die Gefahr einer Rissbildung im Lot, falls die damit thermisch gekoppelten Komponenten unterschiedliche thermische Ausdehnungskoeffizienten besitzen. Abgesehen von diesen Nachteilen bedeutet die Verwendung eines möglichst zuverlässig abgedichteten Kühlers einen hohen Fertigungsaufwand.

Die JP 11-163572 offenbart eine Elektronikeinheit mit einer Leiterplatte, an deren Unterseite eine Kühlmittelwanne angeordnet ist. Diese Kühlmittelwanne weist am oberen Ende der Wannenumrandung eine Dichtung auf, durch die ggf. unter Druck stehendes Kühlmittel nach Außen entweichen kann. Eine weitere Dichtung soll verhindern, dass das ausgetretene, nicht mehr unter Druck stehende Kühlmittel zu den elektronischen Bauelementen auf der Leiterplatte gelangen kann, jedoch ist diese Dichtung in einer Nut der Wandung einer die Leiterplatte umgreifenden Abdeckung angeordnet und muss dort mittel Schrauben angedrückt werden, was einen hohen Fertigungsaufwand mit sich bringt.

Auch die US 2003/0053294 A1 offenbart lediglich die Abdichtung einer Kühlmittelpassage mittels Dichtungen, die mit Hilfe von Schrauben angepresst werden.

Es ist eine Aufgabe der vorliegenden Erfindung, bei einer Elektronikeinheit der eingangs genannten Art die Abdichtung der Kühlmittelpassage zu verbessern bzw. die im Falle einer Undichtigkeit sich ergebenden Risiken zu verkleinern.

Diese Aufgabe wird gemäß der Erfindung durch eine besondere Gestaltung und Anordnung derjenigen Komponenten gelöst, welche die Kühlmittelpassage begrenzen. Ein besonderer Vorteil der Erfindung besteht darin, dass die Unterseite der Bodenplatte unmittelbar mit dem Kühlmittel in Kontakt treten kann, also eine "direkte Kühlung" realisierbar ist.

Gemäß der Erfindung wird die obige Aufgabe durch ein Kühlerteil gelöst, das eine Aussparung und einen einstückig mit dem Kühlerteil ausgebildeten, ringförmig am Rand der Aussparung geschlossen verlaufenden Steg aufweist, dessen Innenseite zusammen mit der Unterseite der Bodenplatte die Kühlmittelpassage begrenzt, wobei die Unterseite der Bodenplatte über eine am Steg verlaufende Dichtungsanordnung kühlmitteldichtend mit dem Steg verbunden ist, welche zwei jeweils ringförmig geschlossen am oberen Ende des Stegs verlaufende Dichtungen umfasst, zwischen denen ein ringförmig geschlossen verlaufender Raum begrenzt wird, der mit einer aus dem Kühlerteil herausführenden Leckagepassage verbunden ist.

Bei dieser Lösung erfolgt eine Abdichtung der Kühlmittelpassage durch eine Dichtungsanordnung an der Unterseite der Elektronik-Bodenplatte. Falls in diesem Bereich eine Undichtigkeit entsteht, so ist durch eine besondere Gestaltung der Dichtungsanordnung dennoch zuverlässig vermieden, dass aus der Kühlmittelpassage austretendes Kühlmittel unmittelbar an die Unterseite der Bodenplatte (und von dort aus gegebenenfalls in den Elektronikraum) gelangt. Die Dichtungsanordnung ist nämlich "mehrstufig" (mit mindestens zwei ringförmig geschlossen verlaufenden Dichtungen) ausgebildet, wobei ein ringförmig geschlossen verlaufender "Zwischenraum" zwischen den Dichtungen mit einer im Undichtigkeitsfall druckentlastenden Leckagepassage verbunden ist. Wenn also in der Kühlmittelpassage befindliches Kühlmedium die erste Dichtung überwinden sollte, so kann dieses über die Leckagepassage in kontrollierter Weise (z. B. von der Elektronik-Bodenplatte weg) abgeführt werden. Je nach Leckrate und Strömungswiderstand der Leckagepassage wird an der zweiten Dichtung nurmehr ein mehr oder weniger beträchtlich verringerter Kühlmitteldruck anliegen.

Für alle oben erläuterten Erfindungsaspekte versteht sich, dass die Kühlmittelpassage vorteilhaft wenigstens einen Einlass und wenigstens einen Auslass zum Einlassen von Kühlmittel bzw. zum Auslassen von Kühlmittel, d. h. zur Durchströmung der Kühlmittelpassage aufweisen kann. Für alle Aspekte kann ein solcher Einlass oder Auslass durch die Bodenplatte, durch den Steg oder durch das Kühlerteil hindurch verlaufen. Ferner können für jeden der Erfindungsaspekte auch mehrere Kühlmittelpassagen vorgesehen sein, die entweder vollkommen separat voneinander (z. B. mit eigenen Einlässen und Auslässen) oder in irgendeiner Weise "verkettet" sein können (z. B. in Parallel- und/oder Reihenanordnung). So kann ein Auslass einer Kühlmittelpassage z. B. gleichzeitig den Einlass einer nachfolgenden Kühlmittelpassage bilden.

Die erfindungsgemäße Elektronikeinheit eignet sich insbesondere zur Verwendung in einer erhöhten Umgebungstemperatur, wie sie beispielsweise im Motorraum eines Kraftfahrzeugs vorliegt.

Insbesondere eine so genannte Leistungselektronik realisierende Elektronikeinheiten können gemäß der Erfindung zuverlässig und relativ gefahrlos gekühlt werden. Hierbei sind insbesondere solche Elektronikeinheiten interessant, bei welchen betriebsmäßig an wenigstens einer Stelle eine elektrische Spannung von mehr als 100 V auftritt und das verwendete Kühlmittel als solches eine Kurzschlussgefahr darstellt und/oder brennbar ist. Eine bevorzugte Anwendung besteht für Steuergeräte eines Kraftfahrzeugs, beispielsweise Motorsteuergeräte, Getriebesteuergeräte etc., insbesondere wenn diese motornah verbaut werden. Für derartige Geräte besteht in der Praxis ein großes Bedürfnis nach Kühlung von mikroelektronischen Bauelementen, insbesondere so genannten Leistungshalbleiterbauelementen. Elektrische Spannungen von mehr als 100 V treten beispielsweise in Steuergeräten für Hybridfahrzeuge und in Steuergeräten zur Ansteuerung von piezobetätigten Kraftstoffeinspritzventilen auf.

In einer bevorzugten Ausführungsform ist vorgesehen, dass die Bodenplatte als Gehäuseteil eines Elektronikmoduls ausgebildet ist, welches einen Teil der elektrischen bzw. elektronischen Bauelemente enthält. Elektronikmodule an sich sind bekannt und bei Demontierbarkeit bzw. Austauschbarkeit besonders vorteilhaft. Die Nutzung eines Modulgehäuseteils als Bodenplatte im Sinne der vorliegenden Erfindung besitzt darüber hinaus jedoch den beträchtlichen Vorteil, dass das betreffende Gehäuseteil, beispielsweise eine Flachseite eines insgesamt etwa quaderförmigen Elektronikmoduls, unmittelbar an die Kühlmittelpassage angrenzt bzw. im Betrieb unmittelbar mit dem Kühlmittel in Kontakt tritt. Es kann besonders vorteilhaft oftmals ein herkömmliches Modul (z. B. mit einer ebenen unteren Flachseite) verwendet werden.

In einer bevorzugten Ausführungsform ist vorgesehen, dass die Bodenplatte als eine Metallplatte ausgebildet ist, die an der Unterseite eines Schaltungsträgers für die elektrischen bzw. elektronischen Bauelemente flächig angebunden ist.

Für die Ausbildung des Schaltungsträgers bzw. des Substrates kann auf im Bereich der Leistungselektronik gängige Technologien zurückgegriffen werden. Ganz allgemein eignet sich ein Lagenaufbau aus einer oder mehreren Leiterbahnschichten, die wenigstens teilweise zur Ausbildung von Leiterbahnen strukturiert (und gegebenenfalls "durchkontaktiert") sind, und einer oder mehreren Isolationsschichten (Dielektrisches Substrat) zumindest zwischen einander benachbarten Leiterbahnschichten. In einer Ausführungsform besitzt eine Schaltungsträgerplatte ein keramisches Substratmaterial und eine oder mehrere Leiterbahnschichten aus metallischem Material. Vorteilhaft kann z. B. eine vergleichsweise geringe Differenz der Wärmeausdehnungskoeffizienten des Substrats (z. B. Keramikmaterial) und des für Leistungselektronik gebräuchlichen Siliziummaterials (von z. B. ungehäust aufgebrachten Siliziumchips) realisiert werden. Selbstverständlich können im Rahmen der Erfindung jedoch auch beliebige andere Schaltungsträger vorgesehen sein.

Die oben erwähnte Anbindung einer Metallplatte an der Unterseite des Schaltungsträgers kann bereits während der Schaltungsträgerfertigung (z. B. bei einem so genannten DCB-Substrat), oder aber nachträglich, z. B. über eine Wärmeleitpaste, einen Wärmeleitkleber oder eine Verlötung, erfolgen. Insbesondere im Hinblick auf eine Anpassung der thermischen Ausdehnungskoeffizienten einerseits eines Schaltungsträgersubstrats und andererseits der als Bodenplatte verwendeten Metallplatte ist in einer Ausführungsform vorgesehen, dass die Bodenplatte aus einer Metalllegierung gebildet ist, beispielsweise aus AlSiC, CuW oder CuMo. Falls die Bodenplatte (oder ein Teil von mehreren Bodenplatten) aus derartigen eher "exotischen" und somit teuren Werkstoffen gefertigt ist, so ist eine Abdichtung der Kühlpassage gemäß der Erfindung vorteilhaft, da die Bodenplatte in ihrer Form weniger komplex (ohne den Steg) ausgebildet werden kann. In diesem Zusammenhang ist auch zu bedenken, dass bei einer Ausführung gemäß der Erfindung vorteilhaft z. B. ein Kühlerteil mit einer Mehrzahl von jeweils ringförmig geschlossen verlaufenden und einstückig ausgebildeten Stegen gleichzeitig als Kühlerteil für mehrere jeweils relativ einfach ausgebildete und kleinerformatige Bodenplatten dienen kann.

Bei dem Kühlmittel handelt es sich bevorzugt um eine Kühlflüssigkeit. Bei einer Verwendung in der Elektronik eines Kraftfahrzeugs kann die Kühlmittelpassage beispielsweise mit dem ohnehin vorhandenen Kühlwasser des Kühlkreislaufes für eine Brennkraftmaschine versorgt werden. Alternativ oder zusätzlich ist die Anbindung der Elektronikeinheit bzw. der darin vorgesehenen Kühlmittelpassage an einen eigens hierfür vorgesehenen Kühlmittelkreislauf möglich. Ein besonders interessanter Anwendungsfall für die Erfindung liegt dann vor, wenn die Kühlmittelpassage zur Aufnahme eines Kühlmittels mit einem Druck von wenigstens 2 bar, insbesondere wenigstens 3 bar ausgelegt ist.

In einer hinsichtlich der Montagefreundlichkeit und Abdichtwirkung für jede Dichtung vorteilhaften Ausführungsform ist vorgesehen, dass der Steg eine Aufnahmenut für die Dichtung bzw. Aufnahmenuten für die Dichtungen aufweist und/oder die über die Dichtung bzw. Dichtungsanordnung mit dem Steg verbundene Komponente, Kühlerteil bzw. Bodenplatte, eine Aufnahmenut für die Dichtung bzw. Aufnahmenuten für die Dichtungen aufweist.

In einer Ausführungsform ist vorgesehen, dass mehrere separat ausgebildete Bodenplatten vorgesehen sind, die über eine entsprechende Anzahl von Dichtungen bzw. Dichtungsanordnungen mit einem gemeinsamen Kühlerteil verbunden sind. Gewissermaßen umgekehrt kann auch vorgesehen sein, dass mehrere separat ausgebildete Kühlerteile vorgesehen sind, die über eine entsprechende Anzahl von Dichtungen bzw. Dichtungsanordnungen mit einem gemeinsamen Bodenteil verbunden sind.

In einer Weiterbildung der Erfindung ist die Kühlmittelpassage mit einer kühloberflächenvergrößernden Struktur ausgebildet. Die Struktur kann z. B. aus dem Material der Bodenplatte bzw. des Kühlteils oder auch als separat angeordnete Struktur (z. B. Metallblech) gebildet sein. Durch geeignete Anbringung bzw. Anordnung solcher Strukturen oder Kühlbleche (wie so genannte "Turbolatoren") kann vorteilhaft auch eine gezielt gelenkte oder turbulente und nicht laminare Strömung in der oder den Kühlpassagen bewerkstelligt werden, um die Kühlwirkung zu verbessern.

Was das Material der im Rahmen der Erfindung verwendeten Dichtung(en) anbelangt, so kann hierfür vorteilhaft auf Materialien zurückgegriffen werden, wie sie im Bereich der Fluidabdichtung gängig sind (z. B. Elastomere).

In einer Ausführungsform ist vorgesehen, dass die Dichtung bzw. wenigstens eine von mehreren Dichtungen als Dichtring ausgebildet ist. Ein solcher Dichtring kann über seine Länge betrachtet z. B. mit im Wesentlichen einheitlichem Querschnitt, insbesondere z. B. kreisförmigem Querschnitt, ausgebildet sein. Alternativ oder zusätzlich können auch z. B. Flachdichtungen (z. B. mit im Wesentlichen rechteckigem Querschnitt) verwendet werden.

Gemäß einer bevorzugten Ausführungsform ist vorgesehen, dass das Bodenteil mit dem Kühlerteil lösbar verbunden, insbesondere z. B. verschraubt ist. Im Hinblick auf eine gute Abdichtung zwischen Bodenplatte und Kühlerteil erfolgt eine Verschraubung bevorzugt durch eine Mehrzahl von Schraubbolzen bzw. Schrauben, so dass in einfacher Weise eine gleichmäßige Anpresskraft über den Verlauf der Dichtung(en) erzielt werden kann. Hierfür ist es besonders günstig, wenn eine Mehrzahl von Verschraubungsstellen etwa dem ringförmig geschlossenen Verlauf einer Dichtung folgend, im Verlauf der Dichtung betrachtet im Wesentlichen äquidistant, vorgesehen ist. Wenn die Abdichtung gemäß der Erfindung erfolgt, so ist zweckmäßigerweise darauf zu achten, dass solche Verschraubungsstellen im Undichtigkeitsfall für ausgetretenes Kühlmittel keinen kurzen Pfad von der Unterseite der Bodenplatte zur Oberseite der Bodenplatte (bzw. andere Bereiche des Elektronikraums) darstellen.

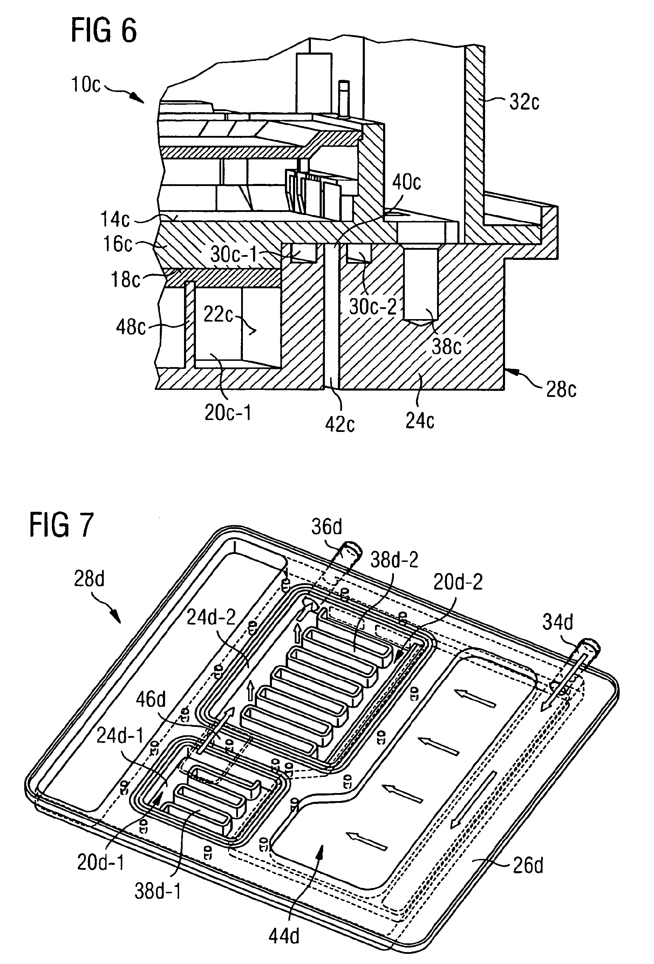

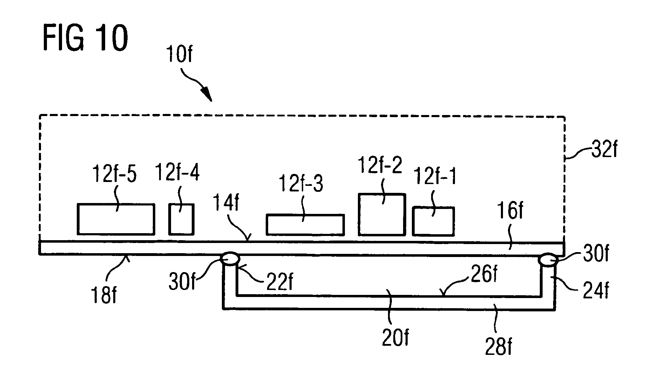

Die Erfindung wird nachfolgend anhand von Ausführungsbeispielen mit Bezug auf die beigefügten Zeichnungen weiter beschrieben. Die Ausführungsbeispiele der Figuren 1, 6 und 10 stellen dabei zum besseren Verständnis der Erfindung den Stand der Technik dar. Es stellen dar:
- Fig. 1: eine schematische Seitenansicht einer Elektronik- einheit,
- Fig. 2: eine perspektivische Ansicht einer Elektronik- Bodenplatte für eine Elektronikeinheit,

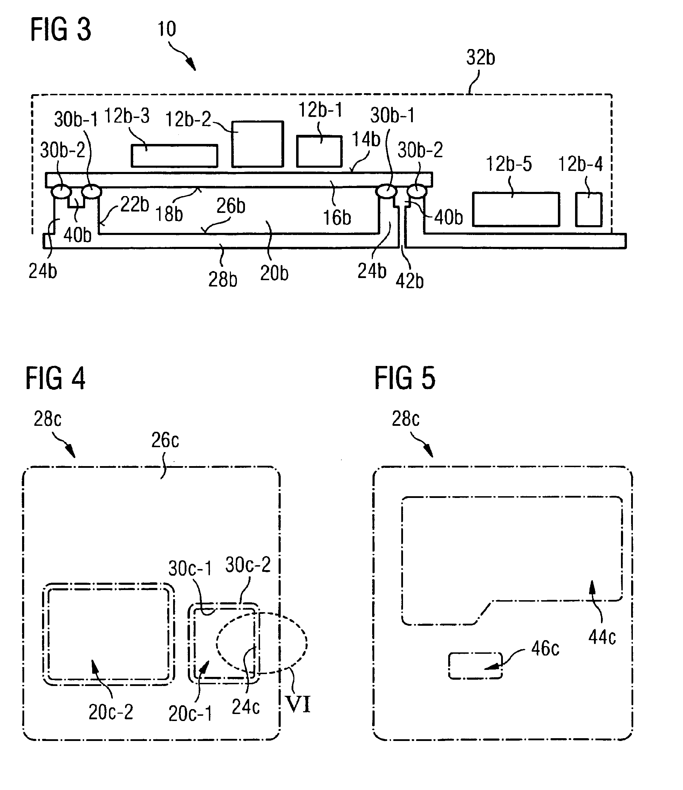

- Fig. 3: eine schematische Seitenansicht einer Elektronik- einheit gemäß der erfindungsgemäßen Ausführungs- form,
- Fig. 4: eine schematische Draufsicht eines plattenförmi- gen Kühlerteils für eine Elektronikeinheit gemäß einer weiteren Ausführungsform,
- Fig. 5: eine schematische des Kühlerteils von Fig. 4, von der entgegengesetzten Seite betrachtet,
- Fig. 6: eine teilweise geschnittene Ansicht der unter Verwendung des Bodenteils gemäß Fig. 4 und 5 ge- bildeten Elektronikeinheit,
- Fig. 7: eine perspektivische Ansicht eines Kühlerteils für eine Elektronikeinheit gemäß einer weiteren Ausführungsform,

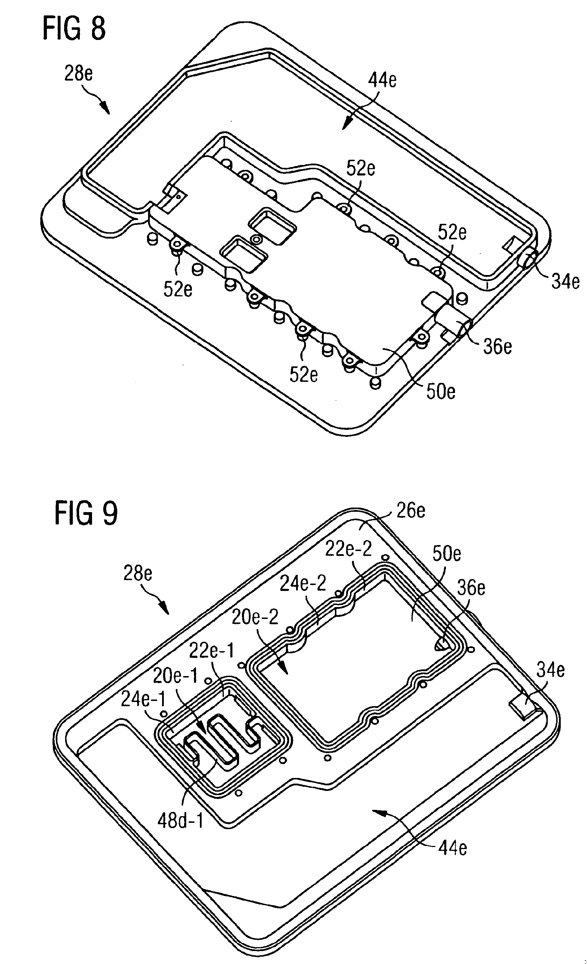

- Fig. 8: eine perspektivische Ansicht eines Kühlerteils für eine Elektronikeinheit gemäß einer weiteren Ausführungsform,
- Fig. 9: eine perspektivische Ansicht des Kühlerteils von Fig. 8, von der entgegengesetzten Seite betrach- tet, und
- Fig. 10: eine schematische Seitenansicht einer Elektronik- einheit gemäß dem Stand der Technik.

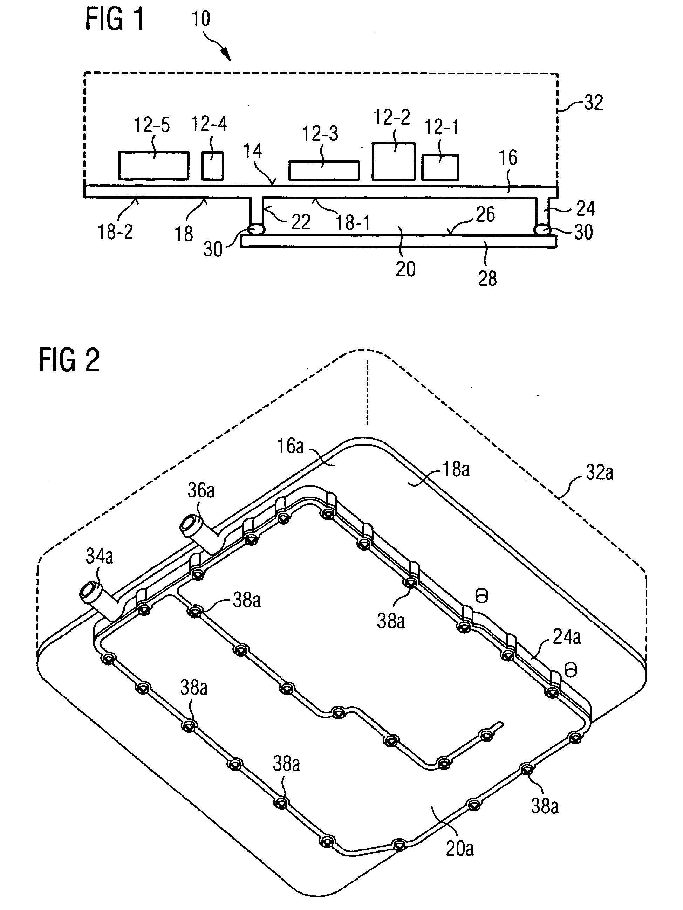

Fig. 1 veranschaulicht ein erstes Ausführungsbeispiel einer Elektronikeinheit 10 (hier: Motorsteuergerät) bei welchem elektrische und elektronische Bauelemente 12-1 bis 12-5 an einer Oberseite 14 einer wärmeleitenden Elektronik-Bodenplatte 16 angeordnet sind.

## Patentansprüche

1. Elektronikeinheit, insbesondere Steuergerät für ein Kraftfahrzeug, mit elektrischen und/oder elektronischen Bauelementen (12b), die an einer Oberseite (14b) einer wärmeleitenden Elektronik-Bodenplatte (16b) angeordnet und thermisch mit dieser Bodenplatte (16b) gekoppelt sind, wobei die Bodenplatte (16b) wiederum thermisch mit einer Kühlmittelpassage (20b) gekoppelt ist,
**gekennzeichnet**
**durch** ein Kühlerteil (28b), das eine Aussparung und einen einstückig mit dem Kühlerteil (28b) ausgebildeten, ringförmig geschlossen am Rand der Aussparung verlaufenden Steg (24b) aufweist, dessen Innenseite (22b) zusammen mit der Unterseite (18b) der Bodenplatte (16b) die Kühlmittelpassage (20b) begrenzt, wobei die Unterseite (18b) der Bodenplatte (16b) über eine am Steg (24b) verlaufende Dichtungsanordnung (30b) kühlmitteldichtend mit dem Steg (24b) verbunden ist, welche zwei jeweils ringförmig geschlossen am oberen Ende des Stegs (24b) verlaufende Dichtungen (30b-1, 30b-2) umfasst, zwischen denen ein ringförmig geschlossen verlaufender Raum (40b) begrenzt wird, der mit einer aus dem Kühlerteil (28b) herausführenden Leckagepassage (42b) verbunden ist.

2. Elektronikeinheit nach Anspruch 1, wobei die Bodenplatte (16b) als Gehäuseteil eines Elektronikmoduls ausgebildet ist, welches zumindest einen Teil der elektrischen bzw. elektronischen Bauelemente (12b) enthält.

3. Elektronikeinheit nach einem der vorangehenden Ansprüche, wobei die Bodenplatte (16b) als eine Metallplatte ausgebildet ist, die an der Unterseite eines Schaltungsträgers für die elektrischen bzw. elektronischen Bauelemente (12b) flächig angebunden ist.

4. Elektronikeinheit nach einem der vorangehenden Ansprüche, wobei die Kühlmittelpassage (20b) zur Aufnahme eines Kühlmittels mit einem Kühlmitteldruck von wenigstens 2 bar, insbesondere wenigstens 3 bar ausgelegt ist.

5. Elektronikeinheit nach einem der vorangehenden Ansprüche, wobei der Steg (24b) Aufnahmenuten für die Dichtungen (30b-1, 30b-2) aufweist.

6. Elektronikeinheit nach einem der vorangehenden Ansprüche, wobei die über die Dichtungsanordnung mit dem Steg (24b) verbundene Bodenplatte (16b) Aufnahmenuten für die Dichtungen (30b-1, 30b-2) aufweist.

7. Elektronikeinheit nach einem der vorangehenden Ansprüche, wobei mehrere separat ausgebildete Bodenplatten (16b) vorgesehen sind, die über eine entsprechende Anzahl von Dichtungsanordnungen (30b-1, 30b-2) mit einem gemeinsamen Kühlerteil (28b) verbunden sind.

## Claims

1. Electronic unit, in particular control unit for a motor vehicle, having electric and/or electronic components (12b) which are arranged on an upper side (14b) of a thermally conductive electronic baseplate (16b) and are thermally coupled to this baseplate (16b), wherein the baseplate (16b) is in turn thermally coupled to a coolant duct (20b),
**characterized**
**in that** by a cooler part (28b) which has a cutout and a web (24b) which is formed in one piece with the cooler part (28b) and extends in a continuous annular shape at the edge of the cutout, the inner side (22b) of said web (24b) bounding, together with the underside (18b) of the baseplate (16b), the coolant duct (20b), wherein the underside (18b) of the baseplate (16b) is connected via a sealing arrangement (30b) running on the web (24b) to the web (24b) in a way which is sealed with respect to the coolant, which sealing arrangement (30b) comprises two seals (30b-1, 30b-2) which each extend in a continuous annular shape at the upper edge of the web (24b), between which seals (30b-1, 30b-2) a space (40b) which extends in a continuous annular shape is bounded, said space (40b) being connected to a leakage duct (42b) which leads out of the cooler part (28b).

2. Electronic unit according to Claim 1, wherein the baseplate (16b) is embodied as a housing part of an electronic module, which housing part contains at least some of the electric and/or electronic component (12b).

3. Electronic unit according to one of the preceding claims, wherein the baseplate (16b) is embodied as a metal plate which is connected over a surface to the underside of a circuit carrier for the electric and/or electronic components (12b).

4. Electronic unit according to one of the preceding claims, wherein the coolant duct (20b) is designed to hold a coolant with a coolant pressure of at least 2 bar, in particular at least 3 bar.

5. Electronic unit according to one of the preceding claims, wherein the web (24b) has grooves for holding the seals (30b-1, 30b-2).

6. Electronic unit according to one of the preceding claims, wherein the base plate (16b) which is connected to the web (24b) via the sealing arrangement has grooves for holding the seals (30b-1, 30b-2).

7. Electronic unit according to one of the preceding claims, wherein a plurality of baseplates (16b) which are formed separately are provided, which baseplates (16b) are connected to a common cooler part (28b) via a corresponding number of sealing arrangements (30b-1, 30b-2).

## Revendications

1. Unité d'électronique, en particulier appareil de pilotage pour un véhicule automobile, comprenant des composants (12b) électriques et/ou électroniques, qui sont disposés sur une face supérieure (14b) d'une plaque de fond d'électronique (16b) thermo-conductrice et sont reliés thermiquement avec cette plaque de fond (16b), la plaque de fond (16b) étant reliée à son tour thermiquement avec un passage pour un moyen de refroidissement (20b),
**caractérisée**
**par** une partie refroidisseur (28b), qui présente un creux et un rebord (24b) réalisé d'une seule pièce avec la partie refroidisseur (28b), qu'il renferme à la façon d'un anneau en entourant le côté extérieur du rebord, le côté intérieur (22b) du rebord délimitant, conjointement avec le côté inférieur (18b) de la plaque de fond (16b), le passage pour le moyen de refroidissement (20b) et la face inférieure (18b) de la plaque de fond (16b) étant reliée, de façon étanche au moyen de refroidissement, au rebord (24b) par le biais d'un dispositif d'étanchéité (30b) positionné au niveau du rebord (24b), lequel dispositif comprend deux joints (30b-1, 30b-2) renfermant respectivement, à la façon d'un anneau, l'extrémité supérieure du rebord (24b) et qui confinent un espace (40b) en forme d'anneau fermé, lequel est relié à un passage de fuite (42b) sortant de la partie refroidisseur (28b).

2. Unité d'électronique selon la revendication 1, la plaque de fond (16b) formant une partie de boîtier d'un module d'électronique, qui contient au moins une partie des composants (12b) électriques ou électroniques.

3. Unité d'électronique selon l'une quelconque des revendications précédentes, la plaque de fond (16b) se présentant sous la forme d'une plaque en métal, qui est liée surfaciquement au côté inférieur d'un porte-circuit dédié aux composants (12b) électriques et/ou électroniques.

4. Unité d'électronique selon l'une quelconque des revendications précédentes, le passage pour le moyen de refroidissement (20b) étant conçu pour le logement d'un moyen de refroidissement avec une pression du moyen de refroidissement d'au moins 2 bars, notamment au moins 3 bars.

5. Unité d'électronique selon l'une quelconque des revendications précédentes, le rebord (24b) présentant des gorges pour insérer les joints (30b-1, 30b-2).

6. Unité d'électronique selon l'une quelconque des revendications précédentes, la plaque de fond (16b) reliée au rebord (24b) par le biais du dispositif d'étanchéité présentant des gorges pour insérer les joints (30b-1, 30b-2).

7. Unité d'électronique selon l'une quelconque des revendications précédentes, plusieurs plaques de fond (16b) formées séparément étant prévues, lesquelles sont reliées, par le biais d'un nombre correspondant de dispositifs d'étanchéité (30b-1, 30b-2), à une partie refroidisseur (28b) commune.
